# EUROPEAN PATENT SPECIFICATION

(11) **EP 2 355 125 B1**
(45) Date of publication and mention of the grant of the patent: **22.04.2015**
(21) Application number: 11152427.8
(22) Date of filing: 27.01.2011
(51) Int. Cl.: H01J 37/145, H01J 37/244, H01J 37/28, H01J 37/05

(54) **Particle beam device and method for operation of a particle beam device**
Teilchenstrahlgerät und Verfahren zum Betreiben eines Teilchenstrahlgeräts
Dispositif de faisceau à particules et procédé de fonctionnement d'un dispositif de faisceau à particules

(30) Priority: 28.01.2010 DE 102010001346
(43) Date of publication of application: 10.08.2011
(73) Proprietor: Carl Zeiss Microscopy GmbH, 07745 Jena (DE)
(72) Inventor: Preikszas, Dirk, 73447 Oberkochen (DE)
(74) Representative: Tongbhoyai, Martin

(56) References cited:
- JP-A- 59 201 357
- US-A- 5 164 594
- US-A1- 2002 079 463
- US-A1- 2008 073 582

## Description

The invention relates to a particle beam device and to a method for operation of a particle beam device.

Electron beam devices, in particular a scanning electron microscope (also referred to in the following text as SEM) are used to examine samples, in order to obtain knowledge about the characteristics and behavior of these samples in specific conditions.

In the case of an SEM, an electron beam (also referred to in the following text as the primary electron beam) is generated by means of a beam generator, and is focused by means of a beam guidance system, in particular an objective lens, onto a sample to be examined. The primary electron beam is passed over a surface of the sample to be examined, in the form of a raster, by means of a deflection device. The electrons in the primary electron beam in this case interact with the material of the sample to be examined. The interaction results in particular in interaction particles. In particular, electrons are emitted from the surface of the sample to be examined (so-called secondary electrons), and electrons are scattered back from the primary electron beam (so-called back-scattered electrons). The secondary electrons and back-scattered electrons are detected, and are used for image production. This therefore results in an image of the surface of the sample to be examined.

It is also known from the prior art for combination device to be used to examine samples, in which both electrons and ions can be passed to a sample to be examined. By way of example, it is known for an SEM to additionally be equipped with an ion beam column. An ion beam generator which is arranged in the ion beam column is used to generate ions, which are used for preparation of a sample, (for example removal of a layer of the sample or application of material to the sample), or else for imaging. In this case, the SEM is used in particular to observe the preparation, or else for further examination of the prepared or unprepared sample.

By way of example, reference is made to DE 10 2006 059 162 A1 with respect to the prior art cited above.
Similar prior art particle beam devices are known from US 5164594 and US 2002/0079463 A1.

In addition to the already mentioned image production, it is also possible to analyze the energy and/or the mass of interaction particles in more detail. For example, a method is known from mass spectroscopy in which secondary ions are examined in more detail. The method is known by the abbreviation SIMS (secondary ion mass spectroscopy). In this method, the surface of a sample to be examined is irradiated with a focused primary ion beam. The interaction particles generated in the process, and which are in the form of secondary ions emitted from the surface of the sample, are detected and examined by mass spectrometry. In the process, the secondary ions are selected and identified on the basis of their ion mass and their ion charge, thus allowing conclusions to be drawn about the composition of the sample.

When analyzing interaction particles, it is desirable to detect as many of the interaction particles as possible in order, for example, to allow good image production or to allow a good statement to be made about the characteristics of the interaction particles, and therefore also of the characteristics of the sample being examined. This results in an interest in good efficiency of a detector (also referred to in the following text as the detector efficiency), with which the interaction particles are detected. Furthermore, in the analysis of the interaction particles, there is also an interest in the energy resolution of the energies of the interaction particles.

It is possible to provide an analysis apparatus, which has a detector for detection of the interaction particles, with an input aperture in order, for example, to shield electrical fields from a primary electron beam or primary ion beam. In order to achieve good detector efficiency in this case as well, it is possible to arrange the input aperture as close as possible to the sample to be examined. In addition, the input aperture can be provided with an extraction potential for generating an extraction field such that as many interaction particles as possible pass through the input aperture into the analysis apparatus.

It is known for a so-called Everhart-Thornley detector to be used for detection of interaction particles in the form of secondary electrons or back-scattered electrons. This detector has a scintillator and a photomultipler. The scintillator is surrounded by a collector, which has an inlet opening in which a grid is arranged. The inlet opening is completely filled by the grid. The collector and the grid are at a variable potential, for example from (-400) V to 400 V. When the grid is at a positive potential, secondary electrons are attracted and detected. However, when the grid is at a negative potential of below (-50) V, then secondary electrons can no longer pass through the grid. In fact, high-energy back-scattered electrons are passed through the grid, and then strike the scintillator.

The extraction field provided by the potential on the grid is generally deformed by the sample and components of an objective lens of a particle beam device. This can lead to the extraction field being inadvertently changed, thus influencing the detector efficiency. There is therefore a need to detect interaction particles both with high energy resolution and with good detector efficiency.

The invention is therefore based on the object of specifying a particle beam device in which interaction particles can be detected with high energy resolution and/or with high efficiency.

According to the invention, this object is achieved by a particle beam device having the features of Claim 1. A method according to the invention is defined by the features of Claim 11. Further features of the invention will become evident from the following description, the following claims and/or from the attached figures.

The particle beam device according to the invention has a sample chamber in which a sample to be examined is arranged. The particle beam device furthermore has a first particle beam column, having a first optical axis, wherein the first particle beam column has a first beam generator for generating a first particle beam and has a first objective lens for focusing the first particle beam onto the sample, wherein, when the first particle beam strikes the sample, interactions between the first particle beam and the sample create first interaction particles. By way of example, the first particle beam column is in the form of an ion beam column, in which the first beam generator generates an ion beam as the first particle beam. The interaction of the ion beam with the sample results in particular in secondary ions, which are emitted from the sample.

Furthermore, the particle beam device according to the invention has a second particle beam column with a second optical axis. The second particle beam column has a second beam generator for generating a second particle beam and has a second objective lens for focusing the second particle beam onto the sample, wherein, when the second particle beam strikes the sample, interactions between the second particle beam and the sample create second interaction particles. By way of example, the second particle beam column is in the form of an electron beam column. In particular, one exemplary embodiment provides for the second particle beam column to be the beam column of a scanning electron microscope. This is used to generate a primary electron beam by means of the second beam generator, which the second objective lens focuses onto the sample. The primary electron beam is passed in the form of a raster scan over a surface of the sample to be examined, by means of a deflection device. In the process, the electrons in the primary electron beam interact with the material of the sample. The interaction results, in particular, in second interaction particles. In particular, secondary electrons are emitted from the surface of the sample, and electrons in the primary electron beam are scattered back (back-scattered electrons). The secondary electrons and the back-scattered electrons are detected, and are used for image production. An image of the surface of the sample to be examined is therefore obtained.

The particle beam device according to the invention furthermore has at least one detector, which is arranged in a first cavity in a first hollow body, wherein the first cavity has a first inlet opening.

Furthermore, the particle beam device according to the invention provides for the first optical axis of the first particle beam column and the second optical axis of the second particle beam column to be arranged on one plane. In contrast, a third axis which is aligned inclined with respect to or at right angles to the abovementioned plane runs from the first inlet opening (for example essentially from the center of the first inlet opening) to the detector (for example essentially to the center of the detector). In each case, the third axis does not lie on the plane on which the first optical axis and the second optical axis lie. If the arrangement of the first particle beam column, of the second particle beam column and of the detector with respect to one another are accordingly considered, then this arrangement corresponds to an arrangement in at least two, and in particular three, different dimensions.

Furthermore, the sample is at a sample potential in the particle beam device according to the invention. Furthermore, the first hollow body is at a first hollow body potential, wherein a first hollow body voltage is a first potential difference between the first hollow body potential and the sample potential. In addition, at least one control electrode which is at a control electrode potential is arranged on the first particle beam column. Furthermore, a control electrode voltage is provided, which is a third potential difference between the control electrode potential and the sample potential. A terminating electrode which is at a terminating electrode potential is in turn arranged on the second particle beam column. Furthermore, a terminating electrode voltage is provided, wherein the terminating electrode voltage is a fourth potential difference between the terminating electrode potential and the sample potential.

The first hollow body voltage, the control electrode voltage and/or the terminating electrode voltage are/is chosen such that an extraction field is generated, such that the first interaction particles and/or the second interaction particles enter the first cavity in the first hollow body through the first inlet opening. This results in the first interaction particles and/or the second interaction particles striking the detector.

Analysis has shown that the particle beam device according to the invention on the one hand ensures good energy resolution and on the other hand good detector efficiency for the detection of the first interaction particles and/or the second interaction particles, for example secondary ions. The latter, in particular, is achieved in that the sample potential, the first hollow body potential, the control electrode potential and/or the terminating electrode potential are/is matched to one another so as to generate an extraction field, such that a sufficient number of first interaction particles and/or second interaction particles pass through the inlet opening of the cavity, and are detected by the detector. If a beam guide tube for the first particle beam column and/or a beam guide tube for the second particle beam column are likewise at a potential, then, in one embodiment of the invention, this potential is also taken into account in the matching of the sample potential, of the first hollow body potential, of the control electrode potential and/or of the terminating electrode potential.

The abovementioned matching of the sample potential, of the first hollow body potential, of the control electrode potential and/or of the terminating electrode potential in order to achieve a sufficient number of first interaction particles and/or second interaction particles is achieved, for example, by varying at least one of the abovementioned potentials until a previously experimentally measured detector efficiency or a computational simulated detector efficiency has been achieved. Alternatively or in addition to this, a further embodiment provides for values which for at least one of the abovementioned potentials, which values have already been stored in a data memory, to be read and to be used, in which case the values are stored in the data memory as a function of the position of the sample with respect to the detector, in particular as a function of a tilted position of the sample. Alternatively or additionally, the values can be stored in the data memory as a function of the working distance, that is to say a position of a sample holder along a z-axis. In particular, a set of values for the first hollow body potential, the control electrode potential and/or the terminating electrode potential is stored in the data memory for a multiplicity of positions of the sample, in particular for a multiplicity of tilted positions, and/or for a multiplicity of working distances. Alternatively or in addition to this, values for at least one of the abovementioned potentials can be interpolated by means of the values stored in the data memory.

In the particle beam device according to the invention, the particle beam device is additionally or alternatively provided with at least one of the following features: the first hollow body voltage can be set by means of a first voltage supply unit, the control electrode voltage can be set by means of a third voltage supply unit, or the terminating electrode voltage can be set by means of a fourth voltage supply unit.

In one embodiment of the particle beam device according to the invention, the detector is additionally or alternatively at a detector potential, wherein a detector voltage is a second potential difference between the detector potential and the sample potential. By way of example, the detector voltage can be set by means of a second voltage supply unit. The first hollow body voltage, the detector voltage, the control electrode voltage and/or the terminating electrode voltage are/is chosen in such a way that an extraction field is generated such that the first interaction particles and/or the second interaction particles enter the first cavity in the first hollow body through the first inlet opening. The sample potential, the first hollow body potential, the detector potential, the control electrode potential and/or the terminating electrode potential are therefore matched to one another in such a way that an extraction field is generated, as a result of which a sufficient number of first interaction particles and/or second interaction particles pass through the first inlet opening in the first cavity, and are detected by the detector.

In yet another embodiment of the particle beam device according to the invention, the control electrode is additionally or alternatively arranged on an outer surface of the first particle beam column. Alternatively, or in addition to this, the control electrode is arranged in a recess on an outer surface of the first particle beam column. Furthermore, additionally or as an alternative to this, the control electrode is arranged in the recess such that an outer surface of the control electrode and the outer surface of the first particle beam column form a continuous surface. However, the invention is not restricted to a specific type, shape and arrangement of the control electrode. In fact, any suitable control electrode may be used. In particular, in one embodiment of the particle beam device according to the invention, the control electrode partially surrounds the first particle beam column. As an alternative to this, the control electrode completely surrounds the first particle beam column.

In one embodiment of the particle beam device according to the invention, the sample potential is alternatively or additionally ground (0 V). Furthermore, the first hollow body potential is additionally or as an alternative to this in the range from (-100) V to (-500) V. Additionally or alternatively to this, the detector potential is in the range from (-10) V to (-500) V. In a further embodiment of the invention, the control electrode potential is additionally or alternatively in the range from 100 V to 800 V, and/or the terminating electrode potential is in the range from (-50) V to (-200) V. In a further embodiment of the particle beam device according to the invention, a beam guide tube for the second particle beam column is at a potential in the range from 1 kV to 30 kV, for example 8 kV, with respect to the sample potential.

In a further embodiment of the particle beam device according to the invention, not only is the detector additionally or as an alternative to this arranged in a cavity in a single hollow body, but the detector is arranged in a plurality of hollow bodies. This embodiment of the particle beam device therefore has a second hollow body with a second cavity. The second hollow body is at a second hollow body potential. A second hollow body voltage is a fifth potential difference between the second hollow body potential and the sample potential. The second hollow body voltage can be set by means of a fifth voltage supply unit. The first hollow body and the second hollow body may, for example, be in the form of tubular electrodes. In particular, the second hollow body is held in the first cavity in the first hollow body. The detector is then held in the second cavity in the second hollow body. The first hollow body potential and the second hollow body potential may be of the same magnitude. In alternative embodiments, the first hollow body potential and the second hollow body potential are of different magnitudes. Analyses have shown that an extraction field is generated by a suitable choice of the first hollow body potential and of the second hollow body potential, taking account of the already previously mentioned sample potentials, the terminating electrode potential, the detector potential and/or the control electrode potential, such that a high detector efficiency is achieved. A sufficient number of first interaction particles and/or second interaction particles pass through the first inlet opening in the first cavity and through the second inlet opening in the second cavity, and are detected by the detector.

In a further embodiment of the particle beam device, the second hollow body potential is additionally or alternatively ground (0 V), and the first hollow body potential is designed to be different to the second hollow body potential. As an alternative to this, the first hollow body potential and the second hollow body potential are not ground (0 V).

In a further embodiment of the particle beam device according to the invention, the first hollow body voltage, the second hollow body voltage and the detector voltage can additionally or alternatively be set by means of a single voltage supply unit, for example by means of the first voltage supply unit. In a further embodiment, the first hollow body voltage and the detector voltage can alternatively be set by means of a single voltage supply unit, for example by means of the first voltage supply unit. In yet another embodiment, the second hollow body voltage and the detector voltage can alternatively be set by means of a single voltage supply unit, for example by means of the fifth voltage supply unit.

In yet another embodiment of the particle beam device according to the invention, the particle beam device has one of the following features:
- the first particle beam column is in the form of an ion beam column, and the second particle beam column is in the form of an electron beam column, or
- the first particle beam column is in the form of an ion beam column, and the second particle beam column is in the form of an ion beam column.

The invention also relates to a method for operation of a particle beam device which has at least one of the abovementioned features or a combination of the abovementioned features. In particular, in the method according to the invention, the first hollow body voltage, the detector voltage, the control electrode voltage and the terminating electrode voltage are provided. Furthermore, the first hollow body voltage, the detector voltage, the control electrode voltage and/or the terminating electrode voltage are/is set such that the first interaction particles and/or the second interaction particles enter the first cavity in the first hollow body through the first inlet opening, as a result of which the first interaction particles and/or the second interaction particles are detected by the detector. In principle, the sample potential, the first hollow body potential, the detector potential, the control electrode potential and/or the terminating electrode potential are matched to one another such that an extraction field is generated, such that a sufficient number of first interaction particles and/or second interaction particles pass through the first inlet opening in the first cavity and are detected by the detector.

If the particle beam device is equipped with two hollow bodies, one embodiment of the method according to the invention additionally or alternatively provides for a first hollow body voltage and a second hollow body voltage to be provided. Furthermore, the first hollow body voltage and the second hollow body voltage are set such that the first interaction particles and/or the second interaction particles enter the second cavity in the second hollow body through the first inlet opening in the first cavity and the second inlet opening in the second cavity. They are then detected by the detector. The sample potential, the first hollow body potential, the second hollow body potential, the detector potential, the control electrode potential and/or the terminating electrode potential are matched to one another such that an extraction field is generated, as a result of which a sufficient number of first interaction particles and/or second interaction particles pass through the second inlet opening in the second cavity, and are detected by the detector.

In one embodiment of the method according to the invention, the sample potential is ground (0 V). Furthermore, additionally or as an alternative to this, the first hollow body potential and/or the second hollow body potential can be set to a value in the range from (-100) V to (-500) V. Additionally or as an alternative to this, the detector potential can be set to a value in the range from (-10) V to (-500) V. In a further embodiment of the method according to the invention, the control electrode potential can additionally or alternatively be set to a value in the range from 100 V to 800 V, and/or the terminating electrode potential can be set to a value in the range from (-50) V to (-200) V. In a further embodiment of the method according to the invention, the beam guide tube for the second particle beam column can be set to a potential in the range from 1 kV to 30 kV, for example 8 kV, with respect to the sample potential.

By way of example, the sample potential, the first hollow body potential, the second hollow body potential, the detector potential, the control electrode potential and/or the terminating electrode potential are set in order to achieve a sufficient number of first interaction particles and/or second interaction particles, by varying at least one of the abovementioned potentials until a previously experimentally measured detector efficiency or a computationally simulated detector efficiency is achieved. Alternatively or in addition to this, a further embodiment provides for values which are already stored in a data memory to be read and to be used for at least one of the abovementioned potentials, wherein the values in the data memory are stored as a function of the position of the sample with respect to the detector, in particular as a function of a tilted position of the sample. Alternatively or additionally, the values can be stored in the data memory as a function of the working distance, that is to say of a position of a sample holder along a z-axis. In particular, a set of values for the first hollow body potential, the second hollow body potential, the control electrode potential and/or the terminating electrode potential is stored in the data memory for each of a multiplicity of positions of the sample, in particular for a multiplicity of tilted positions, and/or for a multiplicity of working distances. Alternatively or in addition to this, values for at least one of the abovementioned potentials can be interpolated by means of the values stored in the data memory.

The invention will now be explained in more detail using exemplary embodiments and with reference to the figures, in which:
Figure 1 shows a schematic illustration of a particle beam device having a first particle beam column and having a second particle beam column;
Figure 2 shows a schematic and perspective illustration of the particle beam device as shown in Figure 1;
Figure 3 shows a schematic illustration of an area of a sample which is arranged in the particle beam device as shown in Figure 2;
Figure 4 shows a schematic illustration of potential lines in the area of the sample as shown in Figure 3;
Figure 5 shows a schematic illustration of an area of a sample which is the basis for a simulation;
Figure 5A shows a schematic illustration of potential lines in the area of the sample as shown in Figure 5;
Figure 6 shows a further schematic illustration of an area of a sample which is arranged in the particle beam device as shown in Figure 2;
Figure 7 shows yet another schematic illustration of an area of a sample which is arranged in the particle beam device as shown in Figure 2, and
Figure 8 shows yet another schematic illustration of an area of a sample which is arranged in the particle beam device as shown in Figure 2.

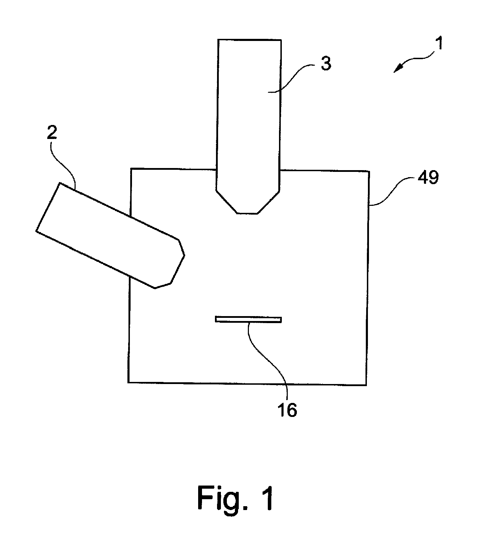

**Figure 1** shows a schematic illustration of one embodiment of a particle beam device 1 according to the invention. The particle beam device 1 has a first particle beam column 2 in the form of an ion beam column, and a second particle beam column 3 in the form of an electron beam column. As an alternative to this, both the first particle beam column 2 and the second particle beam column 3 may each be in the form of an ion beam column. The first particle beam column 2 and the second particle beam column 3 are arranged on a sample chamber 49 in which a sample 16 to be examined is arranged.

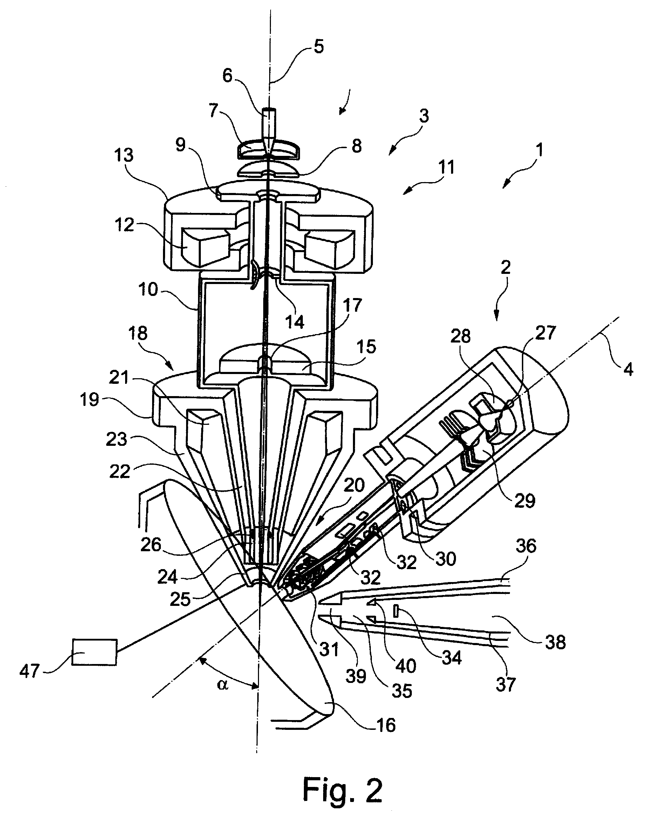

**Figure 2** shows a more detailed illustration of the particle beam device 1 as shown in **Figure 1**. The sample chamber 49 is not illustrated, for clarity reasons. The first particle beam column 2, in the form of the ion beam column, has a first optical axis 4. Furthermore, the second particle beam column 3, in the form of the electron beam column, has a second optical axis 5.

The following text first of all describes the second particle beam column 3 in the form of the electron beam column. The second particle beam column 3 has a second beam generator 6, a first electrode 7, a second electrode 8 and a third electrode 9. By way of example, the second beam generator 6 is a thermal field emitter. The first electrode 7 acts as a suppressor electrode, while the second electrode 8 acts as an extractor electrode. The third electrode 9 is in the form of an anode and at the same time forms one end of a beam guide tube 10. The second beam generator 6 generates a second particle beam in the form of an electron beam. Electrons which emerge from the second beam generator 6 are accelerated to the anode potential because of a potential difference between the second beam generator 6 and the third electrode 9, for example in the range from 1 kV to 30 kV. The second particle beam, in the form of the electron beam, passes through the beam guide tube 10 and is focused onto the sample 16 to be examined. This will be described in more detail further below.

The beam guide tube 10 passes through a collimator arrangement 11 which has a first annular coil 12 and a yoke 13. Seen in the direction from the second beam generator 6 to the sample 16, the collimator arrangement 11 is followed by a variable pinhole diaphragm 14 and a first detector 15 with a central opening 17 in the beam guide tube 10 along the second optical axis 5. The beam guide tube 10 then passes through a hole in a second objective lens 18. The second objective lens 18 is used for focusing the second particle beam onto the sample 16. For this purpose, the second objective lens 18 has a magnetic lens 19 and an electrostatic lens 20. The magnetic lens 19 is provided with a second annular coil 21, an inner pole shoe 22 and an outer pole shoe 23. The electrostatic lens 20 has one end 24 of the beam guide tube 10 and a terminating electrode 25. The end 24 of the beam guide tube 10 and the terminating electrode 25 form an electrostatic delay device. The end 24 of the beam guide tube 10, together with the beam guide tube 10, are at anode potential, while the terminating electrode 25 and the sample 16 are at a lower potential than the anode potential. This allows the electrons in the second particle beam to be braked to a desired energy level, which is required for the examination of the sample 16. The second particle beam column 3 furthermore has raster means 26 by means of which the second particle beam is deflected, and can be scanned in a raster pattern over the sample 16.

For imaging, the first detector 15, which is arranged in the beam guide tube 10, detects secondary electrons and/or back-scattered electrons which are created because of the interaction of the second particle beam with the sample 16. The signals produced by the first detector 15 are transmitted to an electronic unit (not illustrated), for imaging.

The sample 16 is arranged on a sample stage (not illustrated), by means of which the sample 16 is arranged such that it can move on three axes which are arranged perpendicular to one another (specifically an x axis, a y axis and a z axis). Furthermore, the sample stage can be rotated about two rotation axes which are arranged at right angles to one another. It is therefore possible to move the sample 16 to a desired position.

As already mentioned above, the reference symbol 2 denotes the first particle beam column in the form of the ion beam column. The first particle beam column 2 has a first beam generator 27 in the form of an ion source. The first beam generator 27 is used to generate a first particle beam in the form of an ion beam. Furthermore, the first particle beam column 2 is provided with an extraction electrode 28 and a collimator 29. The collimator 29 is followed by a variable aperture 30 along the first optical axis 4 in the direction of the sample 16. The first particle beam is focused onto the sample 16 by means of a first objective lens 31 in the form of focusing lenses. Raster electrodes 32 are provided, in order to scan the first particle beam over the sample 16 in a raster pattern.

When the first particle beam strikes the sample 16, the first particle beam interacts with the material of the sample 16. In the process, first interaction particles are generated, in particular secondary ions, which are emitted from the sample 16. These are now detected by a second detector 34, which will be described in more detail in the following text.

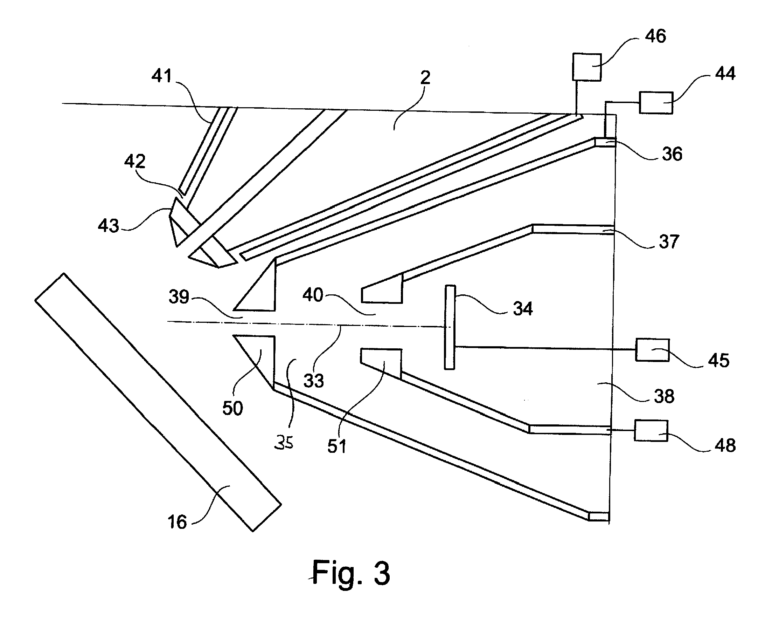

A second hollow body 37 is arranged in a first cavity 35 in a first hollow body 36 in the form of a tubular electrode, and has a second cavity 38. The second hollow body 37 is also in the form of a tubular electrode. The second detector 34 is arranged in the second cavity 38. The first cavity 35 has a first inlet opening 39. Furthermore, the second cavity 38 has a second inlet opening 40. A third axis 33 runs essentially to the center of the second detector 34, essentially from the center of the first inlet opening 39 and essentially from the center of the second inlet opening 40 (cf. **Figure 3****)**.

The first optical axis 4 of the first particle beam column 2 and the second optical axis 5 of the second particle beam column 3 are arranged on one plane. In contrast, the third axis 33 is aligned inclined with respect to or at right angles to the abovementioned plane. The third axis 33 does not lie on the plane on which the first optical axis 4 and the second optical axis 5 are arranged. The arrangement of the first particle beam column 2, of the second particle beam column 3 and of the second detector 34 with respect to one another corresponds to an arrangement in three different dimensions.

**Figure 3** shows a more detailed schematic illustration of an area as shown in **Figure 2**, specifically the area of the sample 16. The figure shows that end of the first particle beam column 2 which is arranged in the area of the sample 16, the second detector 34 as well as the first hollow body 36 and the second hollow body 37. **Figure 3** does not show the second particle beam column 3. That end of the first particle beam column 2 which is arranged in the area of the sample 16 has a control electrode 41. The intention is for the control electrode 41 to partially or completely surround the first particle beam column 2. Furthermore, the control electrode 41 is arranged in a recess 42 on an outer surface 43 of the first particle beam column 2. The outer surface of the control electrode 41 and the outer surface 43 of the first particle beam column 2 form a continuous surface. However, it is explicitly mentioned that the invention is not restricted to the abovementioned arrangement of the control electrode 41. In fact, the control electrode 41 may assume any shape and can be arranged in a way that is suitable for the invention. For example, the control electrode 41 may also be designed to be like a film, with the control electrode 41 which is like a film being wound around the first particle beam column 2. In addition, alternative embodiments provide for no recess to be formed on the outer surface 43 of the first particle beam column 2.

The first hollow body 36 is at a first hollow body potential. A first hollow body voltage is a first potential difference between the first hollow body potential and the sample potential. In this exemplary embodiment, ground potential (0 V) is used as the sample potential, although the sample potential is not restricted to ground potential. In fact, it may also assume a different value. The first hollow body voltage and therefore the first hollow body potential can be set by means of a first voltage supply unit 44.

Furthermore, the second detector 34 is at a detector potential. A detector voltage is a second potential difference between the detector potential and the sample potential. The detector voltage and therefore the detector potential can be set by means of a second voltage supply unit 45.

The control electrode 41 is also at a potential, specifically the control electrode potential. A control electrode voltage is a third potential difference between the control electrode potential and the sample potential. The control electrode voltage and therefore the control electrode potential can be set by means of a third voltage supply unit 46.

A somewhat similar situation applies to the terminating electrode 25 of the second particle beam column 3. The terminating electrode 25 is at a potential, specifically the terminating electrode potential. A terminating electrode voltage is a fourth potential difference between the terminating electrode potential and the sample potential. The terminating electrode voltage and therefore the terminating electrode potential can be set by means of a fourth voltage supply unit 47 (cf. **Figure 2**).

It is envisaged that the second hollow body 37 will also be at a potential, specifically at a second hollow body potential. A second hollow body voltage is a fifth potential difference between the second hollow body potential and the sample potential. The second hollow body voltage and therefore the second hollow body potential can be set by means of a fifth voltage supply unit 48. The first hollow body potential and the second hollow body potential may be of the same magnitude. In further embodiments, the first hollow body potential and the second hollow body potential have different magnitudes.

The sample potential, the first hollow body potential, the second hollow body potential, the detector potential, the control electrode potential and/or the terminating electrode potential are now matched to one another such that an extraction field is generated which ensures that an adequate number of first interaction particles in the form of secondary ions pass through the first inlet opening 39 in the first cavity 35 in the first hollow body 36 and through the second inlet opening 40 in the second cavity 38 in the second hollow body 37, and are detected by the second detector 34.

As already mentioned above, the sample potential in this embodiment is ground potential. It is also envisaged that the first hollow body potential and/or the second hollow body potential will be in the range from (-100) V to (-500) V, the detector potential will be in the range from (-10) V to (-500) V, the control electrode potential will be in the range from 100 V to 800 V and/or the terminating electrode potential will be in the range from (-50) V to (-200) V.

It has been found that when the potential on the beam guide tube 10 in the second particle beam column 3 is 8 kV, essentially 8% of the secondary ions reach the second detector 34 when the first hollow body potential is set to (-200) V, the second hollow body potential is set to (-20) V, the detector potential is set to (-20) V, the terminating electrode potential is set to (-81) V and the control electrode potential is set to 355 V. A first hollow body potential of (-400) V, a second hollow body potential of (-50) V, a detector potential of (-50) V, a terminating electrode potential of (-90) V and a control electrode potential of 600 V result in essentially 15% of the secondary ions reaching the second detector 34.

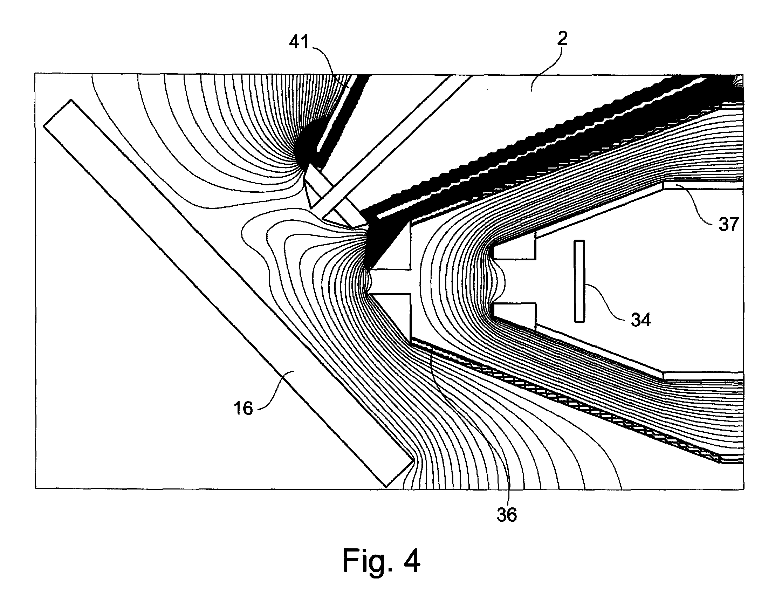

**Figure 4** shows a schematic illustration of the area illustrated in **Figure 3**, with the first hollow body potential being set to (-200) V, the second hollow body potential being set to (-20) V, the detector potential being set to (-20) V, the terminating electrode potential being set to (-81) V and the control electrode potential being set to 355 V. **Figure 4** shows a profile of potential lines of an extraction field, which ensures that the first interaction particles in the form of the secondary ions reach the second detector 34. The interval between the individual potential lines is essentially 10 V.

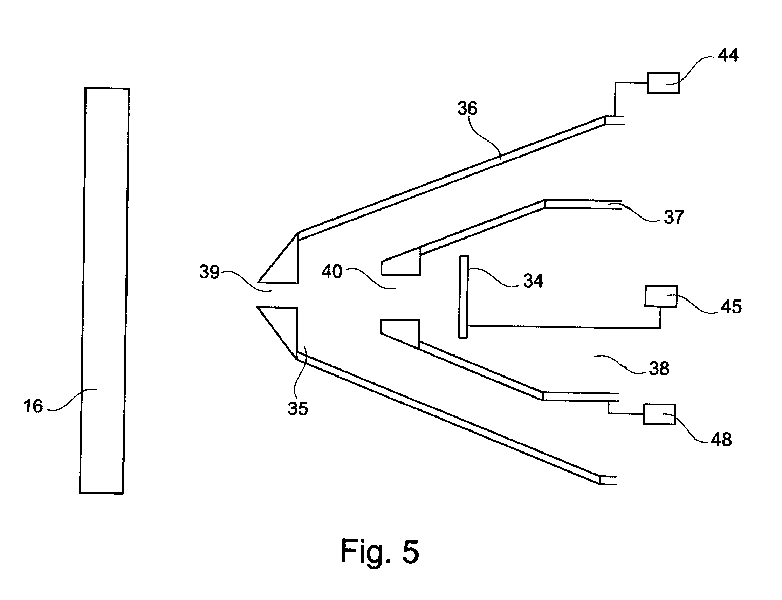

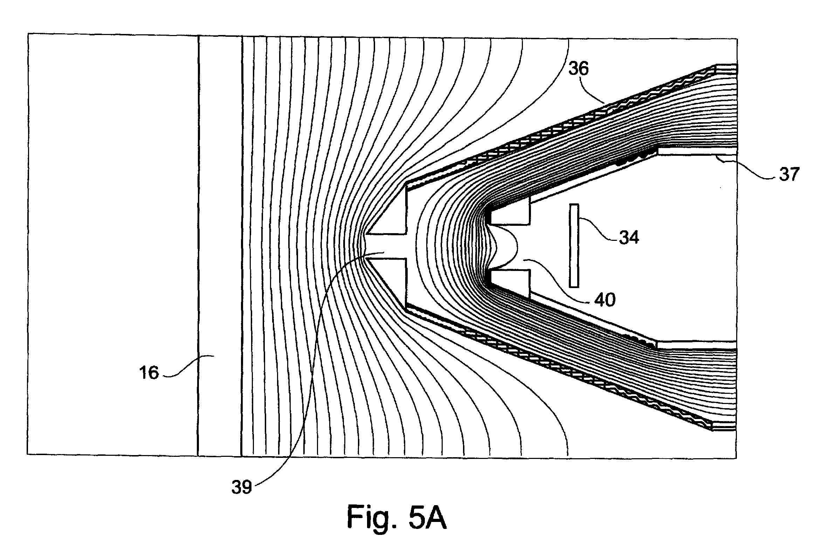

A simulation of a comparison arrangement was carried out in order to check the detector efficiency of the invention. The comparison arrangement is illustrated in **Figure 5**. **Figure** 5 shows the area of the sample 16 of a particle beam device 1, in which case this simulation assumes that the particle beam device 1 has no particle beam column. The simulation assumes that there are no disturbing influences whatsoever, in particular influences which can originate from a particle beam column. The same components in **Figures 1 to 3** are annotated with the same reference symbols in **Figure 5**. In this exemplary embodiment the first hollow body 36, the second hollow body 37 and the second detector 34, which is arranged in the second cavity 38 in the second hollow body 37, are arranged essentially at right angles in front of and to the sample 16. This is advantageous for good detector efficiency, because the arrangement in the immediate vicinity of the sample 16 makes it possible for the second detector 34 to detect a very large number of the secondary ions. An arrangement such as this, as is shown in **Figure 5**, is, however, generally not feasible, since the physical space to do this often does not exist in a particle beam device, and/or further conditions (for example the movement of the sample 16) do not permit an arrangement such as this. In the arrangement illustrated in **Figure 5**, the intention is for individual components to be at a potential. The sample 16 is at the sample potential which, in this exemplary embodiment, corresponds to ground potential. Furthermore, the second detector 34 is at the detector potential, which can be set by means of the second voltage supply unit 45. The first hollow body 36 is at the first hollow body potential, which can be set by means of the first voltage supply unit 44. In addition, the second hollow body 37 is at a potential, specifically the second hollow body potential, which can be set by means of the fifth voltage supply unit 48. Reference is also made to the statements made above, with respect to the setting capability.

In the exemplary embodiment illustrated in **Figure 5**, the detector potential of the second detector 34 and the second hollow body potential are chosen to be the same. In other exemplary embodiments, the detector potential and the second hollow body potential have different values.

As already mentioned above, the sample potential in this embodiment is ground potential (0 V). It is also envisaged that the first and the second hollow body potentials will be in the range from (-200) V to (-500) V, and that the detector potential will be in the range from (-10) V to (-500) V. It has been found that a first hollow body potential of (-200) V, a second hollow body potential of (-20) V and a detector potential of (-20) V result in an extraction field such that essentially 9% of the secondary ions reach the second detector 34. A first hollow body potential of (-400) V, a second hollow body potential of (-50) V and a detector potential of (-50) V result in an extraction field in which essentially 17% of the secondary ions reach the second detector 34. Figure 5A illustrates a profile of the potential lines of the extraction field. To this extent, the simulation has shown that the invention has essentially the same detector efficiency as the comparison arrangement shown in **Figure 5**

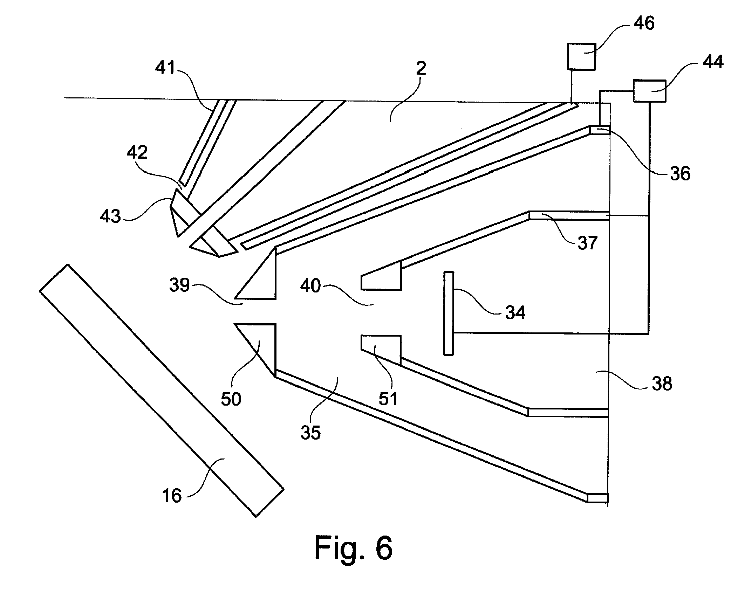

**Figure 6** shows a further schematic illustration of the area of the sample 16. **Figure 6** is based on **Figure 3****,** as a result of which reference will be made first of all to the statements made above. In contrast to the exemplary embodiment shown in **Figure** 3, in the case of the exemplary embodiment shown in **Figure 6**, the first hollow body voltage, the second hollow body voltage and the detector voltage are set by means of a single voltage supply unit, specifically by means of the first voltage supply unit 44.

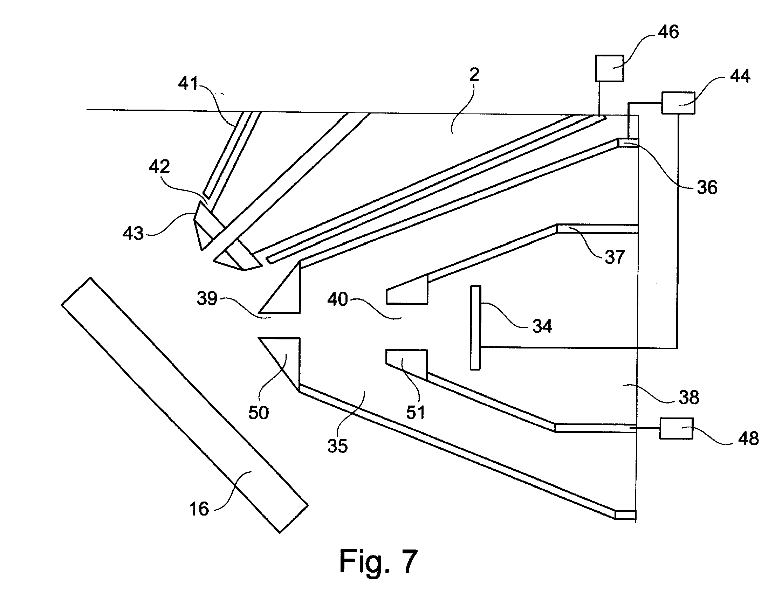

**Figure 7** shows a further exemplary embodiment. **Figure 7** is based on **Figure 3**, as a result of which reference will first of all be made to the statements made above. In contrast to the exemplary embodiment shown in **Figure 3**, in the case of the exemplary embodiment shown in **Figure 7****,** the first hollow body voltage and the detector voltage are set by means of a single voltage supply unit, specifically by means of the first voltage supply unit 44. The second hollow body voltage is set by means of the fifth voltage supply unit 48.

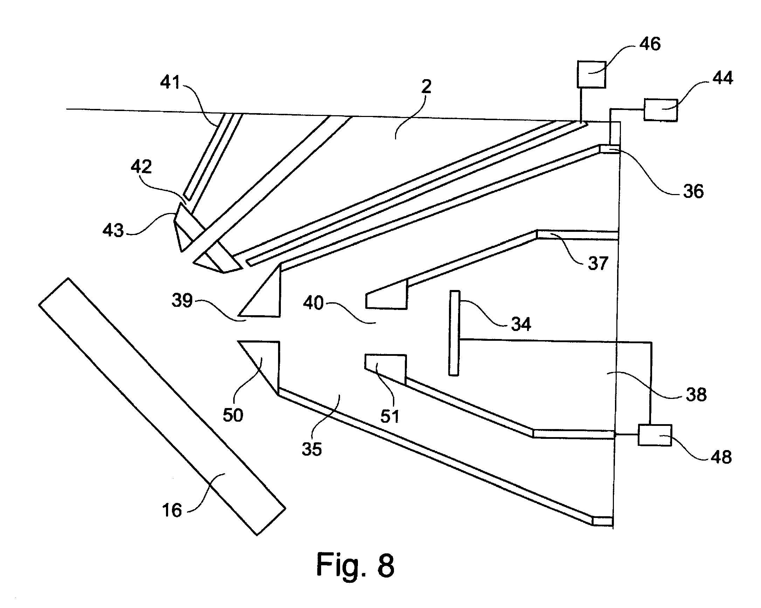

**Figure 8** once again shows a further exemplary embodiment. **Figure 8** is based on **Figure 3****,** as a result of which reference will first of all be made to the statements made above. In contrast to the exemplary embodiment shown in **Figure** 3, in the case of the exemplary embodiment shown in **Figure 8**, the second hollow body voltage and the detector voltage are set by means of a single voltage supply unit, specifically by means of the fifth voltage supply unit 48. The first hollow body voltage is set by means of the first voltage supply unit 44.

The described exemplary embodiments envisage the use of a first hollow body 36 and of a second hollow body 37. However, it is expressly mentioned that the invention is not restricted to the use of two hollow bodies. In fact, further embodiments of the invention envisage more than two hollow bodies being provided. Once again, further embodiments of the invention envisage only a single hollow body 36 being used, in whose first cavity 35 the second detector 34 is arranged.

The second detector 34 may be any desired chosen detector, for example a scintillation detector or a semiconductor detector. In the case of yet other embodiments, it is envisaged that the second detector 34 will be in the form of a spectrometric detection apparatus, for example an apparatus for carrying out SIMS, as already mentioned above.

In a further embodiment of the invention, at least one of the voltage supply units, specifically the first voltage supply unit 44, the second voltage supply unit 45, the third voltage supply unit 46, the fourth voltage supply unit 47 and the fifth voltage supply unit 48, are in the form of a bipolar voltage supply unit. This makes it possible to always set the mathematical sign of the potentials mentioned above such that positively or negatively charged first interaction particles reach the second detector 34.

In yet another embodiment of the invention, the sample potential can be set to a potential other than ground potential. In this case, the control electrode potential, the terminating electrode potential, the detector potential, the first hollow body potential and/or the second hollow body potential can be set to ground potential.

In a further embodiment of the invention, a potential is not provided for the entire first hollow body 36 and the entire second hollow body 37, but only for a first end 50 of the first hollow body 36 to be provided with the first hollow body potential, and for only a second end 51 of the second hollow body 37 to be provided with the second hollow body potential.

All the embodiments of the invention have the advantage that good detector efficiency is ensured when the first interaction particles are detected in the form of secondary ions. The sample potential, the first hollow body potential, the second hollow body potential, the detector potential, the terminating electrode potential and/or the control electrode potential are matched to one another such that an extraction field is generated such that a sufficient number of first interaction particles pass through the first inlet opening 39 and the second inlet opening 40, and are detected by the second detector 34.

### List of reference symbols

- 1: Particle beam device
- 2: First particle beam column (ion beam column)
- 3: Second particle beam column (electron beam column)
- 4: First optical axis
- 5: Second optical axis
- 6: Second beam generator
- 7: First electrode
- 8: Second electrode
- 9: Third electrode
- 10: Beam guide tube
- 11: Collimator arrangement
- 12: First annular coil
- 13: Yoke
- 14: Variable pinhole diaphragm
- 15: First detector
- 16: Sample
- 17: Central opening
- 18: Second objective lens
- 19: Magnetic lens
- 20: Electrostatic lens
- 21: Second annular coil
- 22: Inner pole shoe
- 23: Outer pole shoe
- 24: End of the beam guide tube
- 25: Terminating electrode
- 26: Raster means
- 27: First beam generator
- 28: Extraction electrode
- 29: Collimator
- 30: Variable aperture
- 31: First objective lens
- 32: Raster electrodes
- 33: Third axis
- 34: Second detector
- 35: First cavity
- 36: First hollow body
- 37: Second hollow body
- 38: Second cavity
- 39: First inlet opening
- 40: Second inlet opening
- 41: Control electrode
- 42: Recess
- 43: Outer surface
- 44: First voltage supply unit
- 45: Second voltage supply unit
- 46: Third voltage supply unit
- 47: Fourth voltage supply unit
- 48: Fifth voltage supply unit
- 49: Sample chamber
- 50: First end
- 51: Second end

## Claims

1. Particle beam device (1), having
- a sample chamber (49),
- a sample (16) which is arranged in the sample chamber (49),
- a first particle beam column (2) having a first optical axis (4), wherein the first particle beam column (2) has a first beam generator (27) for generating a first particle beam and has a first objective lens (31) for focusing the first particle beam onto the sample (16) such that the first particle beam strikes the sample (16) and such that first interactions particles are created by interactions between the first particle beam and the sample (16),
- a second particle beam column (3) having a second optical axis (5), wherein the second particle beam column (3) has a second beam generator (6) for generating a second particle beam and has a second objective lens (18) for focusing the second particle beam onto the sample (16), such that the second particle beam strikes the sample (16) and such that second interaction particles are created by interactions between the second particle beam and the sample (16) , and having
- at least one detector (34), which is arranged in a first cavity (35, 38) in a first hollow body (36, 37), wherein the first cavity (35, 38) has a first inlet opening (39, 40), wherein a third axis (33) runs from the first inlet opening (39, 40) to the detector (34),
wherein
- the first optical axis (4) of the first particle beam column (2) and the second optical axis (5) of the second particle beam column (3) are arranged on one plane,
- the third axis (33) is arranged inclined with respect to or at right angles to the plane,
- the sample (16) is at a sample potential,
- the first hollow body (36, 37) is at a first hollow body potential, wherein the particle beam device (1) has a first voltage supply unit (44), wherein a first hollow body voltage is a first potential difference between the first hollow body potential and the sample potential, and wherein the first hollow body voltage is set by means of the first voltage supply unit (44),
- at least one control electrode (41) is arranged on the first particle beam column (2), wherein the particle beam device (1) has a third voltage supply unit (46), wherein the control electrode (41) is at a control electrode potential, wherein
a control electrode voltage is a third potential difference between the control electrode potential and the sample potential wherein the control electrode voltage is set by means of the third voltage supply unit (46),
- the second particle beam column (3) has a terminating electrode (25) which is at a terminating electrode potential, wherein the particle beam device (1) has a fourth voltage supply unit (47), wherein
a terminating electrode voltage is a fourth potential difference between the terminating electrode potential and the sample potential, wherein the terminating electrode voltage is set by means of the fourth voltage supply unit (47), and wherein
- the first hollow body voltage, the control electrode voltage and/or the terminating electrode voltage are/is set such that the first interaction particles and/or the second interaction particles enter the first cavity (35, 38) in the first hollow body (36, 37) through the first inlet opening (39, 40).

2. Particle beam device (1) according to Claim 1, wherein
- the particle beam device (1) has a second voltage supply unit (45), wherein the detector (34) is at a detector potential, wherein a detector voltage is a second potential difference between the detector potential and the sample potential, wherein the detector voltage is set by means of the second voltage supply unit (45), and wherein
- the first hollow body voltage, the detector voltage, the control electrode voltage and/or the terminating electrode voltage are/is set such that the first interaction particles and/or the second interaction particles enter the first cavity (35, 38) in the first hollow body (36, 37) through the first inlet opening (39, 40).

3. Particle beam device (1) according to one of the preceding claims, wherein the particle beam device (1) has one of the following features:
- the control electrode (41) is arranged on an outer surface (43) of the first particle beam column (2),
- the control electrode (41) is arranged in a recess (42) on an outer surface (43) of the first particle beam column (2), or
- the control electrode (41) is arranged in a recess (42) on an outer surface (43) of the first particle beam column (2), wherein an outer surface of the control electrode (41) and the outer surface (43) of the first particle beam column (2) form a continuous surface.

4. Particle beam device (1) according to one of the preceding claims, wherein the particle beam device (1) has one of the following features:
- the control electrode (41) partially surrounds the first particle beam column (2), or
- the control electrode (41) completely surrounds the first particle beam column (2).

5. Particle beam device (1) according to one of the preceding claims, wherein the particle beam device (1) has at least one of the following features:
- the first hollow body potential is in the range from (-100) V to (-500) V,
- the control electrode potential is in the range from 100 V to 800 V, or
- the terminating electrode potential is in the range from (-50) V to (-200) V.

6. Particle beam device (1) according to one of the preceding claims in conjunction with Claim 2, wherein the detector potential is in the range from (-10) V to (-500) V.

7. Particle beam device (1) according to one of the preceding claims, wherein
- the particle beam device (1) has a second hollow body (37) with a second cavity (38),
- the detector (34) is arranged in the second cavity (38) in the second hollow body (37),
- the particle beam device (1) has a fifth voltage supply unit (48),
- the second hollow body (37) is at a second hollow body potential, and
wherein
- a second hollow body voltage is a fifth potential difference between the second hollow body potential and the sample potential, wherein the second hollow body voltage is set by means of the fifth voltage supply unit (48).

8. Particle beam device (1) according to Claim 7, wherein the second hollow body potential is ground, and wherein the first hollow body potential is different to the second hollow body potential.

9. Particle beam device (1) according to Claim 7, wherein the first hollow body potential and the second hollow body potential are not ground.

10. Particle beam device (1) according to one of the preceding claims, wherein the particle beam device (1) has one of the following features:
- the first particle beam column (2) is in the form of an ion beam column, and the second particle beam column (3) is in the form of an electron beam column, or
- the first particle beam column is in the form of an ion beam column, and the second particle beam column is in the form of an ion beam column.

11. Method for operation of a particle beam device (1) according to one of the preceding claims, wherein the method has the following steps:
- providing of a first hollow body voltage,
- providing of a control electrode voltage,
- providing of a terminating electrode voltage, and
- setting of the first hollow body voltage, of the control electrode voltage and/or of the terminating electrode voltage such that the first interaction particles and/or the second interaction particles enter the first cavity (35, 38) in the first hollow body (36, 37) through the first inlet opening (39, 40) in the first cavity (35, 38).

12. Method according to Claim 11, wherein the method has the following steps:
- providing of a detector voltage, and
- setting of the first hollow body voltage, of the detector voltage, of the control electrode voltage and/or of the terminating electrode voltage such that the first interaction particles and/or the second interaction particles enter the first cavity (35, 38) in the first hollow body (36, 37) through the first inlet opening (39, 40) in the first cavity (35, 38).

## Patentansprüche

1. Teilchenstrahlgerät (1), mit
- einer Probenkammer (49),
- einer in der Probenkammer (49) angeordneten Probe (16),
- einer ersten Teilchenstrahlsäule (2) mit einer ersten optischen Achse (4), wobei die erste Teilchenstrahlsäule (2) einen ersten Strahlerzeuger (27) zur Erzeugung eines ersten Teilchenstrahls und eine erste Objektivlinse (31) zur Fokussierung des ersten Teilchenstrahls auf die Probe (16) aufweist, so dass der erste Teilchenstrahl auf die Probe (16) auftrifft und so dass aufgrund von Wechselwirkungen des ersten Teilchenstrahls mit der Probe (16) erste Wechselwirkungsteilchen entstehen,
- einer zweiten Teilchenstrahlsäule (3) mit einer zweiten optischen Achse (5), wobei die zweite Teilchenstrahlsäule (3) einen zweiten Strahlerzeuger (6) zur Erzeugung eines zweiten Teilchenstrahls und eine zweite Objektivlinse (18) zur Fokussierung des zweiten Teilchenstrahls auf die Probe (16) aufweist, so dass der zweite Teilchenstrahl auf die Probe (16) auftrifft und so dass aufgrund von Wechselwirkungen des zweiten Teilchenstrahls mit der Probe (16) zweite Wechselwirkungsteilchen entstehen, und mit
- mindestens einem Detektor (34), der in einem ersten Hohlraum (35, 38) eines ersten Hohlkörpers (36, 37) angeordnet ist, wobei der erste Hohlraum (35, 38) eine erste Eintrittsöffnung (39, 40) aufweist, wobei von der ersten Eintrittsöffnung (39, 40) zu dem Detektor (34) eine dritte Achse (33) verläuft,
wobei
- die erste optische Achse (4) der ersten Teilchenstrahlsäule (2) und die zweite optische Achse (5) der zweiten Teilchenstrahlsäule (3) in einer Ebene angeordnet sind,
- die dritte Achse (33) geneigt oder senkrecht zu der Ebene angeordnet ist,
- die Probe (16) auf einem Probenpotential liegt,
- der erste Hohlkörper (36, 37) auf einem ersten Hohlkörperpotential liegt, wobei das Teilchenstrahlgerät (1) eine erste Spannungsversorgungseinheit (44) aufweist, wobei eine erste Hohlkörperspannung eine erste Potentialdifferenz zwischen dem ersten Hohlkörperpotential und dem Probenpotential ist und wobei die erste Hohlkörperspannung mittels der ersten Spannungsversorgungseinheit (44) eingestellt wird,
- an der ersten Teilchenstrahlsäule (2) mindestens eine Steuerelektrode (41) angeordnet ist, wobei das Teilchenstrahlgerät (1) eine dritte Spannungsversorgungseinheit (46) aufweist, wobei die Steuerelektrode (41) auf einem Steuerelektrodenpotential liegt, wobei
- eine Steuerelektrodenspannung eine dritte Potentialdifferenz zwischen dem Steuerelektrodenpotential und dem Probenpotential ist, wobei die Steuerelektrodenspannung mittels der dritten Spannungsversorgungseinheit (46) eingestellt wird,
- die zweite Teilchenstrahlsäule (3) eine Abschlusselektrode (25) aufweist, welche auf einem Abschlusselektrodenpotential liegt, wobei das Teilchenstrahlgerät (1) eine vierte Spannungsversorgungseinheit (47) aufweist, wobei
- eine Abschlusselektrodenspannung eine vierte Potentialdifferenz zwischen dem Abschlusselektrodenpotential und dem Probenpotential ist, wobei die Steuerelektrodenspannung mittels der vierten Spannungsversorgungseinheit (47) eingestellt wird und wobei
- die erste Hohlkörperspannung, die Steuerelektrodenspannung und/oder die Abschlusselektrodenspannung derart eingestellt ist/sind, dass die ersten Wechselwirkungsteilchen und/oder die zweiten Wechselwirkungsteilchen in den ersten Hohlraum (35, 38) des ersten Hohlkörpers (36, 37) durch die erste Eintrittsöffnung (39, 40) eintreten.

2. Teilchenstrahlgerät (1) nach Anspruch 1, wobei
- das Teilchenstrahlgerät (1) eine zweite Spannungsversorgungseinheit (45) aufweist, wobei der Detektor (34) auf einem Detektorpotential liegt, wobei eine Detektorspannung eine zweite Potentialdifferenz zwischen dem Detektorpotential und dem Probenpotential ist, wobei die Detektorspannung mittels der zweiten Spannungsversorgungseinheit (45) eingestellt wird und wobei
- die erste Hohlkörperspannung, die Detektorspannung, die Steuerelektrodenspannung und/oder die Abschlusselektrodenspannung derart eingestellt ist/sind, dass die ersten Wechselwirkungsteilchen und/oder die zweiten Wechselwirkungsteilchen in den ersten Hohlraum (35, 38) des ersten Hohlkörpers (36, 37) durch die erste Eintrittsöffnung (39, 40) eintreten.

3. Teilchenstrahlgerät (1) nach einem der vorangehenden Ansprüche, wobei das Teilchenstrahlgerät (1) eines der folgenden Merkmale aufweist:
- die Steuerelektrode (41) ist an einer Außenfläche (43) der ersten Teilchenstrahlsäule (2) angeordnet,
- die Steuerelektrode (41) ist in einer Ausnehmung (42) an einer Außenfläche (43) der ersten Teilchenstrahlsäule (2) angeordnet, oder
- die Steuerelektrode (41) ist in einer Ausnehmung (42) an einer Außenfläche (43) der ersten Teilchenstrahlsäule (2) angeordnet, wobei eine Außenfläche der Steuerelektrode (41) und die Außenfläche (43) der ersten Teilchenstrahlsäule (2) eine durchgehende Fläche bilden.

4. Teilchenstrahlgerät (1) nach einem der vorangehenden Ansprüche, wobei das Teilchenstrahlgerät (1) eines der folgenden Merkmale aufweist:
- die Steuerelektrode (41) umschließt die erste Teilchenstrahlsäule (2) teilweise, oder
- die Steuerelektrode (41) umschließt die erste Teilchenstrahlsäule (2) vollständig.

5. Teilchenstrahlgerät (1) nach einem der vorangehenden Ansprüche, wobei das Teilchenstrahlgerät (1) mindestens eines der folgenden Merkmale aufweist:
- das erste Hohlkörperpotential liegt im Bereich von (-100) V bis (-500) V,
- das Steuerelektrodenpotential liegt im Bereich von 100 V bis 800 V, oder
- das Abschlusselektrodenpotential liegt im Bereich von (-50) V bis (-200) V.

6. Teilchenstrahlgerät (1) nach einem der vorangehenden Ansprüche in Verbindung mit Anspruch 2, wobei das Detektorpotential im Bereich von (-10) V bis (-500) V liegt.

7. Teilchenstrahlgerät (1) nach einem der vorangehenden Ansprüche, wobei
- das Teilchenstrahlgerät (1) einen zweiten Hohlkörper (37) mit einem zweiten Hohlraum (38) aufweist,
- der Detektor (34) in dem zweiten Hohlraum (38) in dem zweiten Hohlkörper (37) angeordnet ist,
- das Teilchenstrahlgerät (1) eine fünfte Spannungsversorgungseinheit (48) aufweist,
- der zweite Hohlkörper (37) auf einem zweiten Hohlkörperpotential liegt, und wobei
- eine zweite Hohlkörperspannung eine fünfte Potentialdifferenz zwischen dem zweiten Hohlkörperpotential und dem Probenpotential ist, wobei die zweite Hohlkörperspannung mittels der fünften Spannungsversorgungseinheit (48) eingestellt wird.

8. Teilchenstrahlgerät (1) nach Anspruch 7, wobei das zweite Hohlkörperpotential auf Masse gelegt ist und wobei das erste Hohlkörperpotential unterschiedlich zu dem zweiten Hohlkörperpotential ist.

9. Teilchenstrahlgerät (1) nach Anspruch 7, wobei das erste Hohlkörperpotential und das zweite Hohlkörperpotential nicht auf Masse gelegt sind.

10. Teilchenstrahlgerät (1) nach einem der vorangehenden Ansprüche, wobei das Teilchenstrahlgerät (1) eines der folgenden Merkmale aufweist:
- die erste Teilchenstrahlsäule (2) ist als Ionenstrahlsäule ausgebildet und die zweite Teilchenstrahlsäule (3) ist als Elektronenstrahlsäule ausgebildet, oder
- die erste Teilchenstrahlsäule ist als Ionenstrahlsäule ausgebildet und die zweite Teilchenstrahlsäule ist als Ionenstrahlsäule ausgebildet.

11. Verfahren zum Betreiben eines Teilchenstrahlgeräts (1) nach einem der vorangehenden Ansprüche, wobei das Verfahren die folgenden Schritte aufweist:
- Bereitstellen einer ersten Hohlkörperspannung,
- Bereitstellen einer Steuerelektrodenspannung,
- Bereitstellen einer Abschlusselektrodenspannung sowie
- Einstellen der ersten Hohlkörperspannung, der Steuerelektrodenspannung und/oder der Abschlusselektrodenspannung derart, dass die ersten Wechselwirkungsteilchen und/oder die zweiten Wechselwirkungsteilchen durch die erste Eintrittsöffnung (39, 40) des ersten Hohlraums (35, 38) in den ersten Hohlraum (35, 38) des ersten Hohlkörpers (36, 37) eintreten.

12. Verfahren nach Anspruch 11, wobei das Verfahren die folgenden Schritte aufweist:
- Bereitstellen einer Detektorspannung, und
- Einstellen der ersten Hohlkörperspannung, der Detektorspannung, der Steuerelektrodenspannung und/oder der Abschlusselektrodenspannung derart, dass die ersten Wechselwirkungsteilchen und/oder die zweiten Wechselwirkungsteilchen durch die erste Eintrittsöffnung (39, 40) des ersten Hohlraums (35, 38) in den ersten Hohlraum (35, 38) des ersten Hohlkörpers (36, 37) eintreten.

## Revendications

1. Dispositif à faisceau de particules (1), ayant :
- une chambre d'échantillon (49),
- un échantillon (16) qui est agencé dans la chambre d'échantillon (49),
- une première colonne à faisceau de particules (2) ayant un premier axe optique (4), la première colonne à faisceau de particules (2) ayant un premier générateur de faisceau (27) pour produire un premier faisceau de particules et ayant une première lentille d'objectif (31) pour focaliser le premier faisceau de particules sur l'échantillon (16), de sorte que le premier faisceau de particules vient frapper l'échantillon (16) et de sorte que des premières particules d'interaction sont créées par des interactions entre le premier faisceau de particules et l'échantillon (16),
une seconde colonne à faisceau de particules (3) ayant un second axe optique (5), dans lequel la seconde colonne à faisceau de particules (3) a un second générateur de faisceau (6) pour produire un second faisceau de particules et a une seconde lentille d'objectif (18) pour focaliser le second faisceau de particules sur l'échantillon (16), de sorte que le second faisceau de particules vienne frapper l'échantillon (16), et de sorte que des secondes particules d'interaction sont créées par des interactions entre le second faisceau de particules et l'échantillon (16), et ayant
- au moins un détecteur (34), qui est agencé dans une première cavité (35, 38) d'un premier corps creux (36, 37), la première cavité (35, 38) ayant une première ouverture d'entrée (39, 40), dans lequel un troisième axe (33) s'étend depuis la première ouverture d'entrée (39, 40) vers le détecteur (34),
dans lequel
- le premier axe optique (4) de la première colonne à faisceau de particules (2) et le second axe optique (5) de la seconde colonne à faisceau de particules (3) sont agencés sur un plan,
- le troisième axe (33) est agencé incliné par rapport à ce plan ou à angle droit par rapport à celui-ci,
- l'échantillon (16) est à un potentiel d'échantillon,
- le premier corps creux (37) est à un potentiel de premier corps creux, le dispositif à faisceau de particules (1) ayant une première unité d'alimentation en tension (44), dans lequel une tension de premier corps creux est une première différence de potentiel entre le potentiel de premier corps creux et le potentiel d'échantillon, et dans lequel la tension de premier corps creux est fixée par l'intermédiaire de la première unité d'alimentation en tension (44),
- au moins une électrode de contrôle (41) est agencée sur la première colonne à faisceau de particules (2), le dispositif à faisceau de particules (1) ayant une troisième unité d'alimentation en tension (46), l'électrode de contrôle (41) étant à un potentiel d'électrode de contrôle, dans lequel une tension d'électrode de contrôle est une troisième différence de potentiel entre le potentiel d'électrode de contrôle et le potentiel d'échantillon, la tension d'électrode de contrôle étant fixée par l'intermédiaire de la troisième unité d'alimentation en tension (46),
- la seconde colonne à faisceau de particules (3) a une électrode terminale (25) qui est à un potentiel d'électrode terminale, le dispositif à faisceau de particules (1) ayant une quatrième unité d'alimentation en tension (47), dans lequel une tension d'électrode terminale est une quatrième différence de potentiel entre le potentiel d'électrode terminale et le potentiel d'échantillon, dans lequel la tension d'électrode terminale est fixée par l'intermédiaire de la quatrième unité d'alimentation en tension (47) et dans lequel
- la tension de premier corps creux, la tension d'électrode de contrôle et/ou la tension d'électrode terminale est/sont fixée(s) de telle sorte que les premières particules d'interaction et/ou les secondes particules d'interaction entrent dans la première cavité (35, 38) du premier corps creux (36, 37) à travers la première ouverture d'entrée (39,40).

2. Dispositif à faisceau de particules (1) selon la revendication 1, dans lequel :
- le dispositif à faisceau de particules (1) a une deuxième unité d'alimentation en tension (45), le détecteur (34) étant à un potentiel de détecteur, la tension de détecteur étant une seconde différence de potentiel entre le potentiel de détecteur et le potentiel d'échantillon, la tension de détecteur étant fixée par l'intermédiaire de la deuxième unité d'alimentation en tension (45), et dans lequel :
- la tension de premier corps creux, la tension de détecteur, la tension d'électrode de contrôle et/ou la tension d'électrode terminale est/sont fixée(s) de telle sorte que les premières particules d'interaction et/ou les secondes particules d'interaction pénètrent dans la première cavité (35, 38) dans le premier corps creux (36, 37) à travers la première ouverture d'entrée (39, 40).

3. Dispositif à faisceau de particules (1) selon l'une quelconque des revendications précédentes, dans lequel le dispositif à faisceau de particules (1) a une des caractéristiques qui suivent :
- l'électrode de contrôle (41) est agencée sur une surface extérieure (43) de la première colonne à faisceau de particules (2),
- l'électrode de contrôle (41) est agencée dans un évidement (42) situé sur une surface extérieure (43) de la première colonne à faisceau de particules (2), ou
- l'électrode de contrôle (41) est agencée dans un évidement (42) situé sur une surface extérieure (43) de la première colonne à faisceau de particules (2), où une surface extérieure de l'électrode de contrôle (41) et la surface extérieure (43) de la première colonne à faisceau de particules (2) forment une surface continue.

4. Dispositif à faisceau de particules (1) selon l'une quelconque des revendications précédentes, dans lequel le dispositif à faisceau de particules (1) a une des caractéristiques qui suivent :
- l'électrode de contrôle (41) entoure partiellement la première colonne à faisceau de particules (2), ou
- l'électrode de contrôle (41) entoure entièrement la première colonne à faisceau de particules (2).

5. Dispositif à faisceau de particules (1) selon l'une quelconque des revendications précédentes, dans lequel le dispositif à faisceau de particules (1) a au moins une des caractéristiques qui suivent :
- le potentiel de premier corps creux est dans la plage allant de -100 V à -500 V,
- le potentiel d'électrode de contrôle est dans la plage allant de 100 V à 800 V, ou
- le potentiel d'électrode terminale est dans la plage allant de -50 V à -200 V.

6. Dispositif à faisceau de particules (1) selon l'une quelconque des revendications précédentes, en liaison avec la revendication 2, dans lequel le potentiel de détecteur est dans la plage allant de -10 V à -500 V.

7. Dispositif à faisceau de particules (1) selon l'une quelconque des revendications précédentes dans lequel
- le dispositif à faisceau de particules (1) a un second corps creux (37) ayant une seconde cavité (38),
- le détecteur (34) est agencé dans la seconde cavité (38) du second corps creux (37),
- le dispositif à faisceau de particules (1) a une cinquième unité d'alimentation en tension (48),
- le second corps creux (37) est à un potentiel de second corps creux, et dans lequel
- une tension de second corps creux est une cinquième différence de potentiel entre le potentiel de second corps creux et le potentiel d'échantillon, dans lequel la tension de second corps creux est fixée par l'intermédiaire de la cinquième unité d'alimentation en tension (48).

8. Dispositif à faisceau de particules selon la revendication 7, dans lequel le potentiel de second corps creux est à la terre, et dans lequel le potentiel de premier corps creux est différent du potentiel de second corps creux.

9. Dispositif à faisceau de particules (1) selon la revendication 7, dans lequel le potentiel de premier corps creux et le potentiel de second corps creux ne sont pas à la terre.

10. Dispositif à faisceau de particules (1) selon l'une quelconque des revendications précédentes, dans lequel le dispositif à faisceau de particules (1) a une des caractéristiques qui suivent :
- la première colonne à faisceau de particules (2) a la forme d'une colonne à faisceau d'ions, et la seconde colonne à faisceau de particules (3) a la forme d'une colonne à faisceau d'électrons, ou
- la première colonne à faisceau de particules a la forme d'une colonne à faisceau d'ions, et la seconde colonne à faisceau de particules a la forme d'une colonne à faisceau d'ions.

11. Procédé pour actionner un dispositif à faisceau de particules (1) selon l'une des revendications précédentes, dans lequel le procédé comporte les étapes qui suivent :
- fournir une tension de premier corps creux,
- fournir une tension d'électrode de contrôle,
- fournir une tension d'électrode terminale, et
- fixer la tension de premier corps creux, la tension d'électrode de contrôle et/ou la tension d'électrode terminale de telle sorte que les premières particules d'interaction et/ou les secondes particules d'interaction pénètrent dans la première cavité (35, 38) du premier corps creux (36, 37) à travers la première ouverture d'entrée (39, 40) de la première cavité (35, 38).

12. Procédé selon la revendication 11, dans lequel le procédé a les étapes qui suivent :
- fournir une tension de détecteur, et
- fixer la tension de premier corps creux, la tension de détecteur, la tension d'électrode de contrôle et/ou la tension d'électrode terminale de telle sorte que les premières particules d'interaction et/ou les secondes particules d'interaction pénètrent la première cavité (35, 38) dans le premier corps creux (36, 37) à travers la première ouverture d'entrée (39, 40) dans la première cavité (35, 38).
